Europäisches Patentamt

European Patent Office

Office européen des brevets

(19)

(11) Publication number: **0 040 032**
**B1**

(12) **EUROPEAN PATENT SPECIFICATION**

(45) Date of publication of patent specification: **09.11.83**

(21) Application number: **81301960.1**

(22) Date of filing: **05.05.81**

(51) Int. Cl.³: **H 01 L 21/268,**
**H 01 L 21/225**

(54) The manufacture of a semiconductor device.

(30) Priority: **14.05.80 JP 63571/80**

(43) Date of publication of application:
**18.11.81 Bulletin 81/46**

(45) Publication of the grant of the patent:
**09.11.83 Bulletin 83/45**

(84) Designated Contracting States:
**DE FR GB NL**

(56) References cited:
**EP - A - 0 015 677**
**EP - A - 0 028 678**
**EP - A - 0 037 261**
**US - A - 4 181 538**

**IBM TECHNICAL DISCLOSURE BULLETIN, Vol.
22, No. 9, February 1980 New York T. H. YEH
"Self-Aligned Integrated NPN (Vertical) and PNP
(Lateral) Structures" pages 4047 to 4051
IBM TECHNICAL DISCLOSURE BULLETIN, Vol.
21, no. 10, March 1979 New York R. F. LEVER
"Background Heating for Laser Annealing" page
4040**

(73) Proprietor: **FUJITSU LIMITED**
**1015, Kamikodanaka Nakahara-ku
Kawasaki-shi Kanagawa 211 (JP)**

(72) Inventor: **Sakurai, Junji**
**7-11, Seta 4-chome
Setagaya-ku Tokyo 158 (JP)**

(74) Representative: **Sunderland, James Harry et al,
HASELTINE LAKE & CO Hazlitt House 28
Southampton Buildings Chancery Lane
London WC2A 1AT (GB)**

Courier Press, Leamington Spa, England.

## The manufacture of a semiconductor device

The present invention relates to the manufacture of a semiconductor device, and is concerned with a method of diffusing an impurity in the course of manufacture of a semiconductor device.

There are known methods of diffusion of a type in which an impurity providing a specified conductivity type is diffused from a layer, containing that impurity, on a substrate into the substrate. One such method uses an insulating film containing an impurity and another uses a semiconductor layer containing an impurity.

Figures 1A to 1E of the accompanying drawings are respective schematic sectional views illustrating a method of diffusing an impurity in which method a phosphosilicate-glass (PSG) film is employed as an insulating film containing an impurity.

In Figure 1A, 1 is a p type silicon semiconductor substrate, whilst 2 is a silicon dioxide ($SiO_2$) film.

The $SiO_2$ film 2 is provided with a window at a specified area thereof.

In Figure 1B, 3 is a PSG film. This PSG film 3 contains about 20% phosphorus and has a thickness of about 1 $\mu$m.

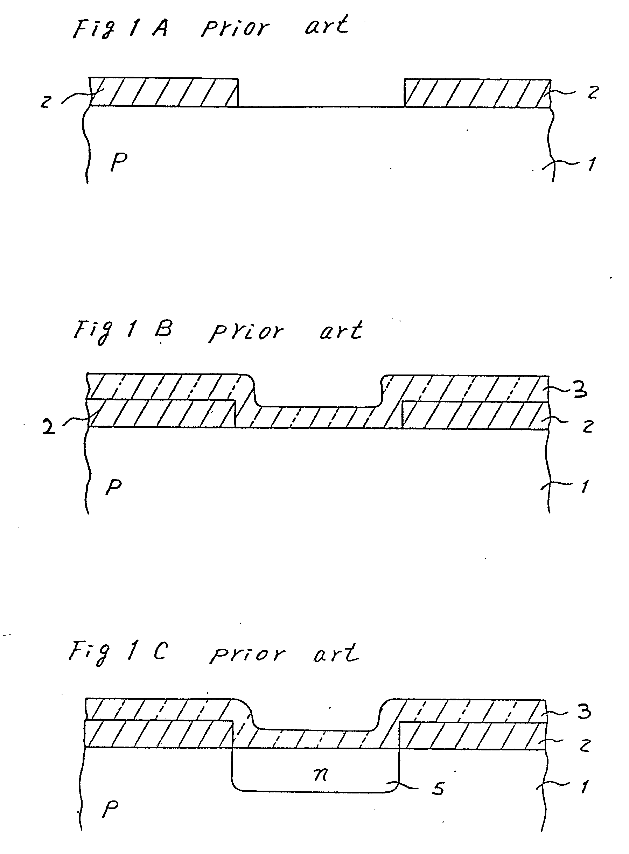

In a process illustrated by Figure 1C, the semiconductor substrate 1 is annealed for about 20 minutes at a temperature of about 1050°C in a nitrogen ($N_2$) atmosphere. Thereby, an n type impurity region 5 is formed by diffusion. The depth of the region 5 is about 0.4 $\mu$m and its surface resistance $\rho_s$ is about 20 $\Omega$/square.

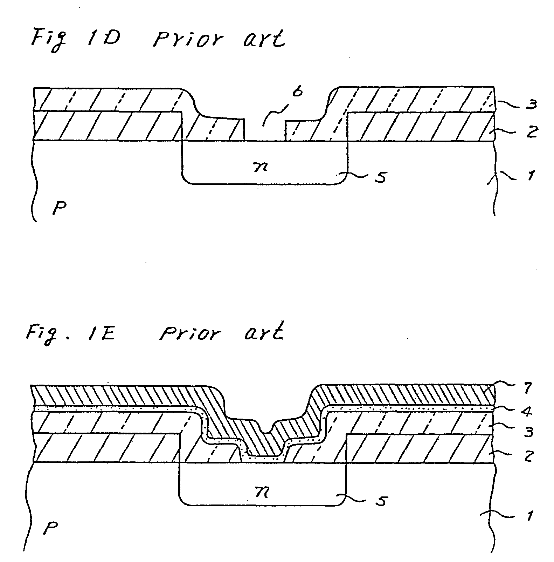

With a view to obtaining an electrical connection to this impurity region 5, a window 6 is formed as shown in Figure 1D.

As illustrated in Figure 1E, an aluminium layer (Al) 7 is ordinarily used to provide a contact electrode for region 5. When steps are taken for obtaining an ohmic contact between the region 5 and the Al layer 7 provided on the semiconductor substrate, a status change into an alloy of the Al and Si sometimes proceeds abnormally, with a result that the shallow pn junction formed in the semiconductor substrate 1 is destroyed. Therefore, there is employed a method in which a thin polycrystalline silicon layer 4 is formed on the exposed silicon substrate surface before Al layer 7 is formed, and then after formation of the Al layer 7 on the layer 4, the Al and Si are alloyed.

Usually, a thermal process for providing roundness (rounded edges) for the window in the PSG layer 3 is carried out in advance in order to prevent disconnection or discontinuity of the Al layer 7.

As explained above, an impurity diffusion method utilizing an insulation film containing an impurity to be diffused involves a variety of processes, and moreover requires that a variety of factors to be taken into account to provide for the leading out of a low resistance contact electrode from the impurity diffused region (5) formed in the semiconductor substrate.

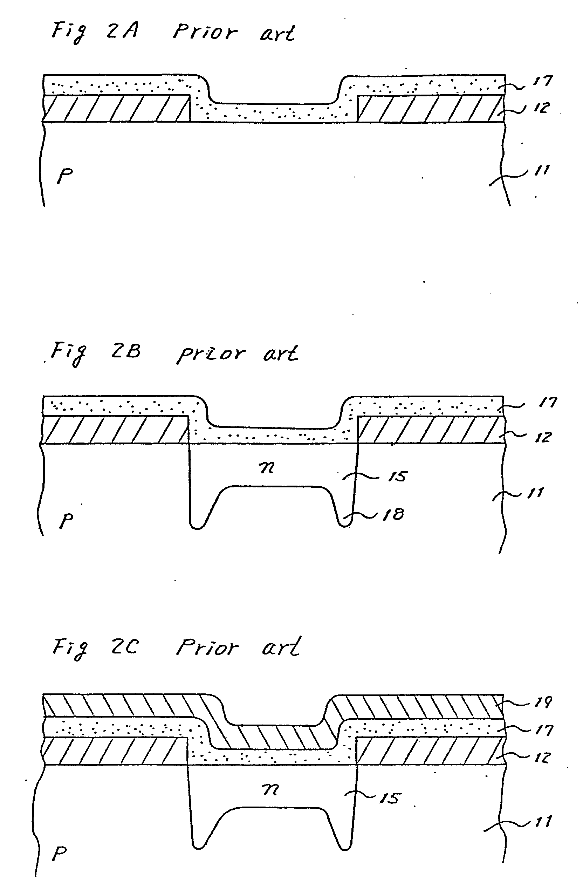

Figures 2A to 2C are respective schematic sectional views illustrating an impurity diffusion method in which a polycrystalline silicon layer is used as a semiconductor layer containing an impurity.

In Figure 2A, 11 is a p type silicon semiconductor substrate; 12 is a silicon dioxide film; 17 is a polycrystalline silicon layer.

The thickness of polycrystalline silicon (poly-Si) layer 17 is about 0.4 $\mu$m. This poly-Si of the layer may contain an impurity (e.g. phosphorus) at the time of formation of the layer or a non-doped poly-Si layer may be formed initially and impurity (e.g. phosphorus) introduced subsequently.

Thereafter, annealing is carried out for about 20 minutes at a temperature of about 1050°C in a $N_2$ atmosphere. Thereby, a n type impurity region 15 is formed by diffusion, as indicated in Figure 2B. The depth of the impurity region 15 at its centre is about 0.4 $\mu$m, but its depth at parts thereof around the edges of the window in $SiO_2$ film 12 is about 0.7 to 0.8 $\mu$m as indicated by 18 in Figure 2B.

This deeply diffused impurity region 18 is usually called the "Dragon teeth" and is believed to be generated as an effect of causes explained hereunder.

(i) Distortion occurring inside the silicon substrate 1 as a consequence of the difference of expansion coefficients of $SiO_2$ film 12 and poly-Si layer 17. This distortion allows impurity to diffuse abnormally into lattice defects generated thereby.

(ii) The impurity (e.g. phosphorus) contained in the poly-Si layer 17 extending over the $SiO_2$ film 12 is concentrated at parts around the edge of the window in film 12 and then diffused into the substrate.

However, such a deeply diffused impurity region 18 is not formed in the impurity diffusion method utilising PSG film as illustrated in Figures 1A to 1E. For this reason, the inventor of the present invention thinks that cause (i) is actually the major factor accounting for such "Dragon teeth".

In the impurity diffusion method utilising poly-Si, it is possible to execute diffusion processes, and thereafter to carry out patterning of the remaining poly-Si layer and to use the poly-Si layer directly as wiring. However, in the case of ordinary poly-Si containing an impurity, the surface resistance is comparatively large, being about 50 to 70 $\Omega$/square.

When a poly-Si layer is used as an impurity diffusion source, a contact electrode can be led rather easily from the diffused region (15) and the process for providing the contact electrode is simplified.

In Figure 2C, 19 is an Al electrode. To obtain

an ohmic contact between the electrode 19 and the n type impurity diffusion region 15 it is required only to alloy the poly-Si layer 17 used for the impurity diffusion and the Al layer 19.

As explained previously, it is possible in a method for diffusing impurity from a layer containing the impurity to form a shallow diffusion region in a minute area.

However, either it is difficult to lead out a contact electrode or element characteristics are detrimentally affected by abnormal diffusion in a part of the diffusion region.

For these reasons, there is required an impurity diffusion method in which the problems of the abovementioned conventional techniques are avoided.

According to Article 54.3, of the EPC, a method of manufacturing a semiconductor device comprising providing a semiconductor layer, part of it containing an impurity, on a dielectric layer covering a substrate, and irradiating the semiconductor layer with a high energy beam to diffuse the impurity in lateral direction within said layer (EP—A—0028678) and a method of manufacturing a semiconductor device comprising providing a semiconductor layer on a substrate, containing an impurity, and irradiating the semiconductor device with a high energy beam, simultaneously to melt the semiconductor layer and to diffuse the impurity into the layer (EP—A—0 037 261) are comprised in the state of the art.

According to the present invention there is provided a method of manufacturing a semiconductor device, comprising:—

providing a semiconductor layer, containing an impurity, on a semiconductor substrate, and

irradiating the semiconductor layer with a high energy beam, simultaneously to melt the semiconductor layer and to diffuse the impurity into the substrate.

An embodiment of the present invention can provide for the upgrading of element characteristics through the provision of an impurity diffusion of uniform depth, by diffusion of an impurity from a semiconductor layer containing the impurity into a semiconductor substrate.

An embodiment of the present invention can make it possible to extract a contact electrode having a low resistance from an impurity diffusion region formed in a semiconductor substrate.

An embodiment of the present invention can provide for a reduced resistance value of a contact electrode provided from an impurity diffusion region formed in a semiconductor substrate and can improve element characteristics.

Briefly, an embodiment of the present invention provides an impurity diffusion method comprising the steps of:—

forming selectively an insulating layer having a window on a semiconductor substrate,

forming a semiconductor layer containing an impurity on said insulating layer and in said window,

melting a part of the semiconductor layer and substrate by irradiating them with a high energy beam and diffusing an impurity contained in the semiconductor layer into the substrate.

Here, the semiconductor layer containing an impurity may contain an impurity when it is formed, or the impurity may be introduced into the layer after formation. In addition, the semiconductor layer may be a polycrystalline semiconductor layer or amorphous semiconductor layer.

In an embodiment of the present invention, the semiconductor layer containing an impurity is irradiated with a high energy beam, and a single-crystalline semiconductor layer is consequently left on the substrate and is used as a contact electrode extending from an impurity diffusion region.

A portion of the semiconductor layer and substrate is melted when irradiated by a high energy beam and an impurity diffusion region having uniform depth is momentarily formed through impurity diffusion. Simultaneously, an ohmic contact having a low resistance is obtained between the semiconductor layer and the impurity diffusion region. Additionally, the semiconductor layer is single-crystallised and is directly used as the contact electrode having a low resistance.

Reference is made, by way of example, to the accompanying drawings, in which:—

Figures 1A to 1E and Figures 2A to 2C are respective schematic sectional views illustrating various stages in previously proposed production processes; and

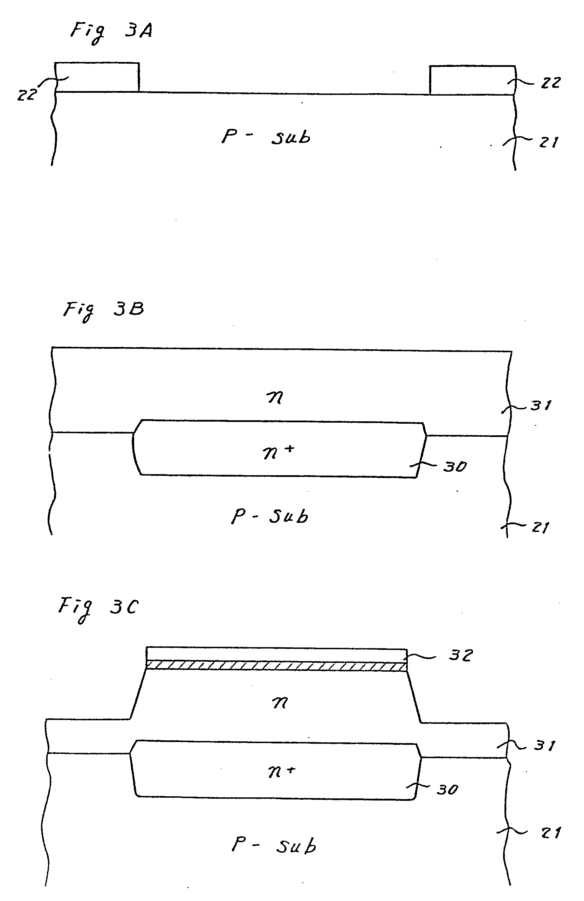

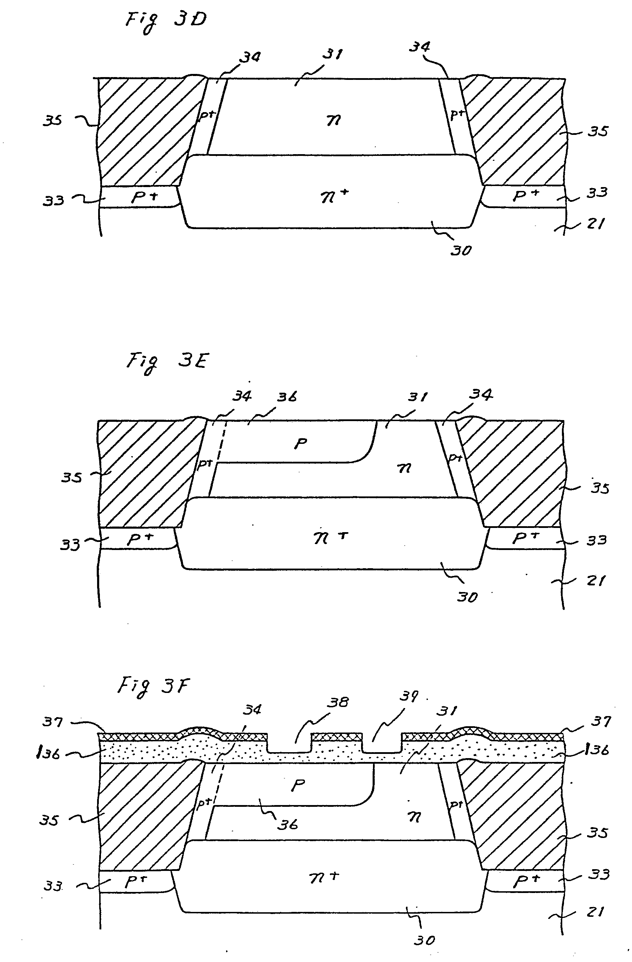

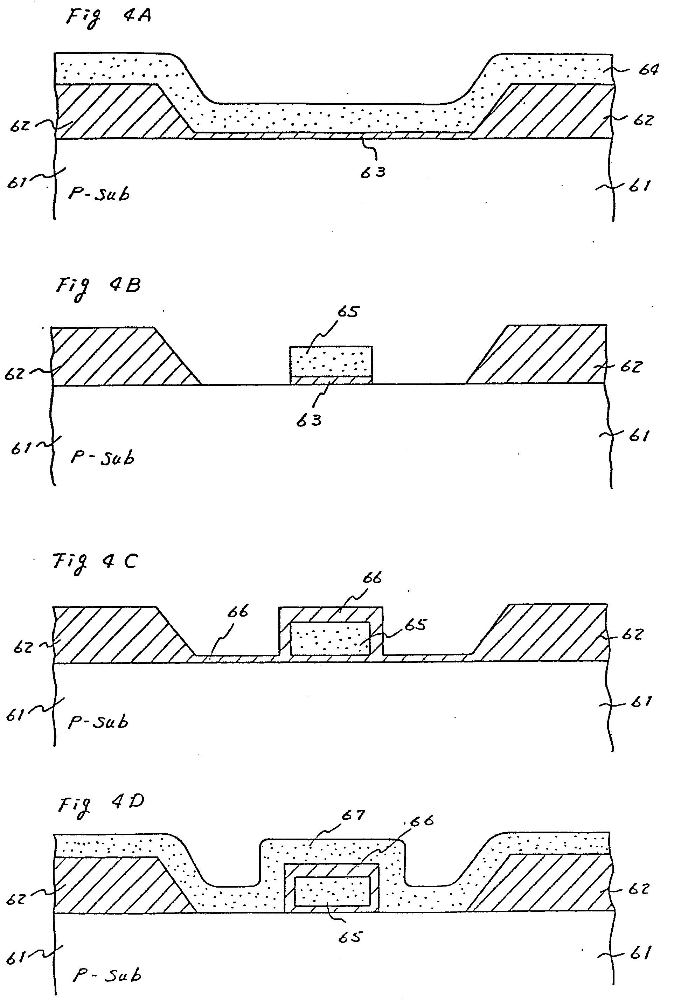

Figures 3A to 3I and Figures 4A to 4G are respective schematic sectional views illustrating various stages in the production of semiconductor devices in accordance with embodiments of the present invention.

Figures 3A to 3I illustrate an embodiment of the present invention for the production of a walled emitter type bipolar transistor.

In Figure 3A, 21 is a p type silicon substrate the main surface of which is a (100) surface, whilst 22 indicates a resist film formed as a mask.

Antimony (Sb) ions are implanted through the substrate surface at an energy of 100 KeV and a dose amount of $1 \times 10^{15}$ cm$^{-2}$. Then, after removing the resist film 22, a silicon dioxide film (not shown) is formed on the substrate surface. Thereafter, annealing is carried out for about 70 minutes at a temperature of 1200°C in a dry N$_2$ ambient in order to activate the implanted ions.

After removing the silicon oxide film an n type epitaxial silicon layer is formed on the substrate to a thickness of about 1.5 μm.

In Figure 3B, 30 is an n$^+$ type buried portion, having a conductivity type determined by the activated Sb ions, whilst 31 is an n type epitaxial silicon layer formed through thermal decomposition of monosilane ($SiH_4$). At the time of formation of the epitaxial layer 31, $P_2O_5$ is mixed into the reaction gas and thereby n type conductivity is provided.

Next, as illustrated in Figure 3C, a silicon dioxide film is formed on the epitaxial layer 31, to a thickness of about 50 nm, by a thermal oxidation process, and then a silicon nitride (Si$_3$N$_4$) film 32 is formed to a thickness of about 100 Å by an ordinary CVD (Chemical Vapour Deposition) method, sequentially (not illustrated).

Thereafter, after etching of the silicon nitride film and the silicon dioxide film by an ordinary photo etching method, etching of the exposed silicon surface through a thickness of about 0.8 $\mu$m is carried out using potassium hydroxide (KOH) as etching solution. The silicon epitaxial layer 31 has a surface (100) as its main surface and a tapered groove is formed by anisotropic etching using the KOH.

Boron ions are implanted through the surface of layer 31 using the silicon nitride film 32 and silicon oxide film as a mask. Here, the dose amount is $1 \times 10^{13}$ cm$^{-2}$ and the energy is 50 KeV.

Then, the implanted ions are activated by a thermal process carried out in a wet $O_2$ atmosphere and the silicon dioxide layer is caused to grow in the said groove to such a thickness as to provide a substantially flat surface.

In Figure 3D, 33, 34 are p$^+$ type regions provided with that conductivity type by the activated boron ions, and 35 is the thick silicon dioxide film.

Thereafter, a resist film (not shown) is selectively formed on the surface (the upper surface in Figure 3D). Then, boron ions are implanted using the resist film as a mask with a dose amount of $1 \times 10^{14}$ cm$^{-2}$ and an energy of 100 KeV.

Succeedingly, a thermal process is carried out in an $N_2$ atmosphere in order to activate the implanted ions and thereby a p type base region is formed.

In Figure 3E, 36 indicates the p type base region.

Then, a poly-Si layer is formed to a thickness of about 0.4 $\mu$m over the entire (upper) surface and then an Si$_3$N$_4$ film of a thickness of about 50 nm is formed, sequentially.

In Figure 3F, 136 is the poly-Si layer, whilst 37 is the Si$_3$N$_4$ film.

After selectively removing parts of the Si$_3$N$_4$ film 37, etching through a thickness of about 0.2 $\mu$m is carried out selectively for the poly-Si layer 136 using the remaining parts of the Si$_3$N$_4$ film 37 as a mask.

One groove 38 formed by this etching of the poly-Si layer 136 is formed on the base region 36, whilst another groove 39 bridges over the base region 36 and the (collector) region 31.

Thereafter, the poly-Si layer 136 is selec-

tively oxidised using the Si$_3$N$_4$ film 37 as a mask.

In Figure 3G, 40, 41 are silicon dioxide layers and 42 is a resist film formed as a mask.

Then, phosphorus ions are implanted using the resist 42 bridging over the silicon oxide films 40, 41 as a mask. This ion implantation is carried out with a dose amount of about $5 \times 10^{16}$ cm$^{-2}$ and an energy of about 150 KeV. Therefore, all ions implanted remain in the poly-Si layer 136.

Thereafter, a mask (not illustrated) consisting of inverted resist 42 is formed and boron ions are implanted. Namely, ions are implanted into the region covered by mask 42 in the preceding step. Here, dose amount is about $5 \times 10^{16}$ cm$^{-2}$ and implantation energy is about 50 KeV.

Thereafter, a laser is used to irradiate the polycrystalline semiconductor layer with a high energy beam.

Here, the substrate is heated up in advance to 500°C and a CW Ar laser is used. Moreover, the irradiation with the laser is effected at a scan speed of about 10 cm/sec with a power of 5 W and a spot size of 50 $\mu$m.

Thereby, the poly-Si layer and substrate are partly melted, resulting in impurity diffusion.

The impurity diffusion rate in melted silicon is very high as compared with that in solid silicon and therefore there is no time for generation of lattice defects due to the difference between the thermal expansion coefficients of the silicon dioxide layer and poly-Si layer. Thus the impurity diffusion process is completed.

Resultingly, a shallow impurity diffusion region having a uniform depth can be obtained without generating abnormal diffusion in parts near to a boundary with insulating film.

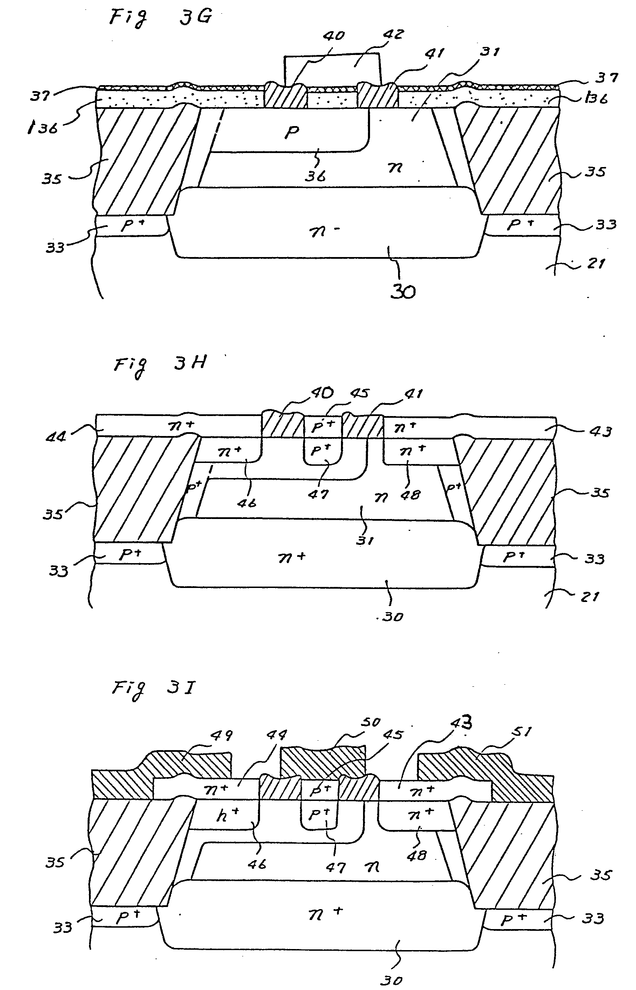

In Figure 3H, 43, 44 are single-crystallised n$^+$ type polycrystalline semiconductor layer parts; 45 is a single-crystallised p$^+$ polycrystalline semiconductor layer part; 46 is an n$^+$ type emitter region of a depth of about 0.2 $\mu$m; 47 is a p$^+$ type base contact region of a depth of about 0.2 $\mu$m; 48 is an n$^+$ type collector contact region of a depth of about 0.2 $\mu$m.

The poly-Si layer 136 is melted and single-crystallised by irradiation with a laser beam, thus forming the single-crystalline silicon layer parts 43, 44, 45. The surface resistance $\rho_s$, which was about 50 to 70 $\Omega$/square in the poly-Si layer, is reduced to 20 to 30 $\Omega$/square by the single-crystallisation.

Since the impurity diffused regions 46, 47 and 48, and the single-crystallised semiconductor layers 44, 45 and 43 are melted respectively by the irradiation with a laser beam, an ohmic contact with a low resistance value is formed.

In Figure 3I, 49 is an emitter electrode consisting of an Al layer structure; 50 is a base electrode consisting of an Al layer structure; 51 is a collector electrode consisting of an Al layer structure, respectively.

Since the semiconductor layer connected to an impurity diffusion region is single-crystallised, it can be used directly as a contact electrode, through patterning thereof, without any problem, and it can also be connected with metal electrodes as required as shown in Figure 3I.

Namely, since an ohmic contact having a low resistance is obtained between a semiconductor layer and an impurity diffusion region, for metal electrodes, for example of aluminium, it is required only to connect an electrode with a semiconductor layer.

For this reason, the shallow pn junction is not destroyed by an alloy of the silicon and the electrode aluminium, and also electrodes can be lead out by a simple process, because the electrodes are not directly connected to impurity diffusion regions.

Figures 4A to 4G illustrate an embodiment of the present invention for the manufacture of a silicon gate type MOS transistor.

In Figure 4A, 61 is a p type silicon substrate having a specific resistance of 10 to 20 $\Omega$cm; 62 is a thick silicon dioxide ($SiO_2$) layer for element isolation; 63 is a gate oxide film, as thin as 50 nm, in an element forming area; 64 is a poly-Si layer of a thickness of about 400 nm.

Phosphorus ions are implanted from the surface with a dose amount of $4 \times 10^{16}$ cm$^{-2}$ and an energy of 50 KeV. Succeedingly, annealing is carried out for about 20 minutes at a temperature of about 1050°C in a $N_2$ atmosphere in order to activate the implanted ions.

Thereafter, the phosphorus doped poly-Si layer 64 and the thin $SiO_2$ film 63 are etched by an ordinary photo-etching method.

In Figure 4B, 65 is a gate electrode consisting of remaining poly-Si layer after etching; and 63 is the gate oxide film remaining under the gate electrode after etching, respectively.

It is conventionally known that a poly-Si layer containing an impurity has a high oxidation rate as compared with that of a single-crystalline semiconductor layer.

Therefore, whilst the surface of silicon substrate 61 is oxidized to a thickness of about 50 nm, the surface of the gate electrode consisting of phosphorus doped poly-Si layer 64 is oxidised to a thickness of about 400 nm.

In Figure 4C, 66 is an $SiO_2$ layer formed in such an oxidation process. Such oxidation process is executed at a temperature of about 850°C in a wet $O_2$ atmosphere.

Next, the thin part of oxide film 66 formed on the substrate surface is removed by reactive ion etching using carbon tetrafluoride ($CF_4$) as reaction gas. Even after the substrate surface has been perfectly exposed by this reactive ion etching process, a silicon oxide film thicker than 300 nm still remains on the gate electrode 65.

Succeedingly, a poly-Si layer is formed to a thickness of about 400 nm over the entire exposed (upper) surface by an ordinary CVD method.

In Figure 4D, 66 is the silicon oxide layer remaining on the gate electrode, and 67 is the poly-Si layer.

Then, phosphorus (P) ions or arsenic (As) ions are implanted through the surface with a dose amount of $4 \times 10^{16}$ cm$^{-2}$ and an energy of about 50 KeV, followed by a process for activation of the implanted ions, carried out in a $N_2$ atmosphere.

Thereafter, impurity diffusion is effected by irradiating the poly-Si layer with a high energy laser beam.

Here, the substrate is heated up in advance to a temperature of about 500°C, and a CW Ar laser is used to provide the high energy beam. Thus, poly-Si layer is irradiated by a laser beam with a power of 5 W, a spot size of about 50 $\mu$m and a scan speed of about 10 cm/sec.

Thereby, the poly-Si containing an impurity, and a part of semiconductor substrate, are melted, and impurity diffusion and single-crystallisation of the poly-Si layer are carried out simultaneously.

In Figure 4E, 68 is the resulting single-crystallised n$^+$ type semiconductor layer; and 69, 70 are source and drain regions of a depth of about 0.2 $\mu$m formed by impurity diffusion.

Next, after forming selectively a resist film on areas except for those near to the gate electrode, etching is carried out until at least the silicon oxide film 66 covering the gate electrode is exposed, using an etching solution of HF; $HNO_3$; buffer.

In Figure 4F, 71 is a resist mask; 66 is the exposed oxide film on the gate electrode; 68a is a source electrode; and 68b is a drain electrode.

Then, after removing the resist 71, a protection film is formed over the entire (upper) surface, or an oxide film is formed over the entire (upper) surface, thus completing formation of an element.

As explained above, in relation to an embodiment of the present invention for a manufacture of a bipolar transistor, a connection electrode can be connected to an impurity diffusion region with a low resistance, and such a contact electrode itself has a low specific resistance such as 20 to 30 $\Omega$/square as compared with a conventional electrode.

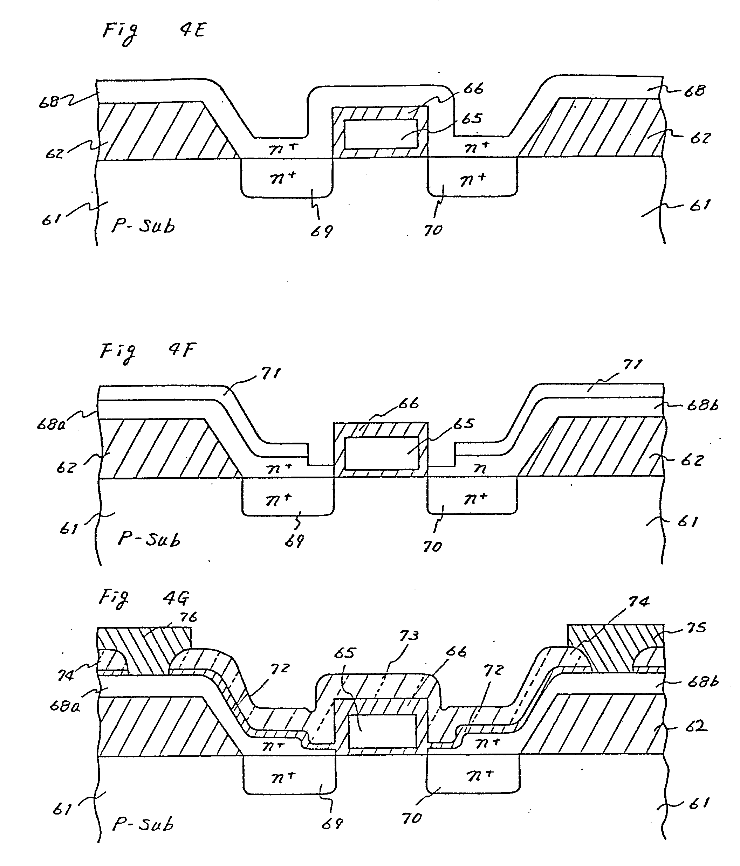

As shown in Figure 4G, it is effective for an embodiment of the present invention to combine with the Al wiring.

In Figure 4G, 72 is a silicon dioxide layer obtained by oxidising the surface of single-crystallised semiconductor layer 68; 73 is a PSG film; 74 indicates windows in the PSG film, melted in order to prevent disconnection of Al wiring; 75 is a drain electrode consisting of Al; 76 is a source electrode consisting of Al.

As shown in Figure 4G, the present invention allows for the connection of electrodes to take place on the thick oxide film provided for interelement isolation. This makes it possible very easily to lead out electrodes from the source and drain regions which conventionally would have had to be done in the comparatively narrow area and is also effective for improving production yield.

As explained previously, embodiment of the present invention provide for the diffusion of an impurity to a uniform depth, from a semiconductor layer containing the impurity into a semiconductor substrate, and also provide for improved element characteristics.

In addition, according to an embodiment of the present invention, a contact electrode can be extended with a low resistance from an impurity diffusion region formed inside the semiconductor substrate.

Moreover, the resistance value of a contact electrode itself can be reduced and element characteristics can be improved by single-crystallising the contact electrode.

The embodiments of the present invention explained above employ a semiconductor layer which is a polycrystalline semiconductor layer, but alternatively an amorphous semiconductor layer can be used.

Embodiments of the present invention can also be realised by irradiating with an Ar laser, a ruby laser, and also with the use of an ion beam, or a photon beam or an electron beam etc., as the high energy beam.

In an embodiment of the present invention, a shallow uniform impurity diffusion region can be obtained in a semiconductor substrate through the steps of forming an insulating film, having a window therein, on the semiconductor substrate, then forming a semiconductor layer on the insulating film and on the semiconductor substrate exposed in the window, and diffusing a specified impurity from this semiconductor layer into the semiconductor substrate with melting of the semiconductor layer by a high energy beam.

Simultaneously, the melted semiconductor layer is single-crystallised and can be used as a contact electrode having a low resistance extending from the impurity diffusion region. Here, impurity diffusion into the semiconductor layer which acts as impurity diffusion source may be performed at the time of forming the semiconductor layer or after the formation of the semiconductor layer. As the high energy beam, it is practical to use a laser beam.

Thus, an embodiment of the present invention provides a method of manufacturing a semiconductor device, comprising:—

providing a semiconductor layer, containing an impurity, on a semiconductor substrate, irradiating the semiconductor layer with a high energy beam, to melt the semiconductor layer and a portion of the substrate and to diffuse the impurity into the substrate, and selectively etching the semiconductor layer to form a contact electrode for a portion of the substrate into which impurity is diffused.

Especially, single-crystallisation of the semiconductor layer through the irradiation with the high energy beam can provide a contact electrode of low resistance.

**Claims**

1. A method of manufacturing a semiconductor device, comprising:—

providing a semiconductor layer, containing an impurity, on a semiconductor substrate; and irradiating the semiconductor layer with a high energy beam, simultaneously to melt the semiconductor layer and to diffuse the impurity into the substrate.

2. A method as claimed in claim 1, in which the semiconductor layer containing an impurity is formed of semiconductor material including the impurity.

3. A method as claimed in claim 1, in which the semiconductor layer containing an impurity is provided by first forming a layer of semiconductor then diffusing the impurity into the layer of semiconductor.

4. A method as claimed in claim 1, 2 or 3, in which an insulating layer having a window is formed on the semiconductor substrate, and the semiconductor layer is provided on the substrate in the window, and on the insulating layer.

5. A method as claimed in claim 3, in which the semiconductor layer is selectively oxidised, for example to provide an oxide barrier between two parts of the semiconductor layer so that different impurities can be diffused respectively into the two parts of the semiconductor layer.

6. A method as claimed in any preceding claim, in which, after irradiation of the semiconductor layer with the high energy beam, the semiconductor layer is selectively etched to form a contact electrode for a portion of the substrate into which impurity has been diffused from the semiconductor layer.

7. A method as claimed in any preceding claim, wherein the semiconductor layer is either a polycrystalline layer or an amorphous layer.

8. A method as claimed in any preceding claim, wherein the high energy beam is a laser beam.

9. A method as claimed in any preceding claim, wherein, in preparation for the irradiation of the semiconductor layer with the high energy beam, the substrate is heated.

10. A method as claimed in any preceding claim, wherein the semiconductor layer and the semiconductor substrate are of silicon.

**Revendications**

1. Un procédé de fabrication d'un dispositif à semiconducteur, dans lequel:

on établit sur un substrat semiconducteur une couche semiconductrice contenant une impureté; et

on irradie la couche semiconductrice avec un faisceau de haute énergie, pour faire fondre la couche semiconductrice et faire diffuser simultanément l'impureté dans le substrat.

2. Un procédé selon la revendication 1, dans lequel la couche semiconductrice contenant une impureté est formée par une matière semiconductrice contenant l'impureté.

3. Un procédé selon la revendication 1, dans lequel la couche semiconductrice contenant une impureté est établie en formant tout d'abord une couche de semiconducteur puis en diffusant l'impureté dans la couche de semiconducteur.

4. Un procédé selon la revendication 1, 2 ou 3, dans lequel on forme sur le substrat semiconducteur une couche isolante contenant une fenêtre, et on établit la couche semiconductrice sur le substrat, dans le fenêtre, et sur la couche isolante.

5. Un procédé selon la revendication 3, dans lequel on oxyde sélectivement la couche semiconductrice, par exemple pour établir une barrière d'oxyde entre deux parties de la couche semiconductrice, afin que des impuretés différentes puissent être diffusées dans les deux parties respectives de la couche de semiconducteur.

6. Un procédé selon n'importe quelle revendication précédente, dans lequel, après irradiation de la couche de semiconducteur avec le faisceau de haute énergie, on attaque sélectivement la couche semiconductrice pour former une électrode de contact pour une partie du substrat dans laquelle une impureté a été diffusée à partir de la couche semiconductrice.

7. Un procédé selon n'importe quelle revendication précédente, dans lequel la couche semiconductrice est une couche polycristalline ou une couche amorphe.

8. Un procédé selon n'importe quelle revendication précédente, dans lequel le faisceau de haute énergie est un faisceau laser.

9. Un procédé selon n'importe quelle revendication précédente, dans lequel on chauffe le substrat, en préparation pour l'irradiation de la couche semiconductrice avec le faisceau de haute énergie.

10. Un procédé selon n'importe quelle revendication précédente, dans lequel la couche semiconductrice et le substrat semiconducteur sont en silicium.

**Patentansprüche**

1. Verfahren zur Herstellung eines Halbleiterbauelementes, gekennzeichnet durch Bildung einer eine Verunreinigung enthaltende Halbleiterschicht auf einem Halbleitersubstrat, und durch Bestrahlung der Halbleiterschicht mit einem Strahl hoher Energie, um gleichzeitig die Halbleiterschicht zu schmelzen und die Verunreinigung in das Substrat zu diffundieren.

2. Verfahren nach Anspruch 1, bei welchem die eine Verunreinigung enthaltende Halbleiterschicht aus einem Halbleitermaterial gebildet wird, welches die Verunreinigung enthält.

3. Verfahren nach Anspruch 1, bei welchem die eine Verunreinigung enthaltende Halbleiterschicht gebildet wird, in dem zuerst eine Halbleiterschicht ausgebildet und dann die Verunreinigung in diese Halbleiterschicht diffundiert wird.

4. Verfahren nach einem der Ansprüche 1, 2 oder 3, bei welchem eine isolierende Schicht, welche ein Fenster aufweist, auf dem Halbleitersubstrat gebildet wird und die Halbleiterschicht auf dem Substrat in dem Fenster und auf der isolierenden Schicht gebildet wird.

5. Verfahren nach Anspruch 3, bei welchem die Halbleiterschicht selektiv oxidiert wird, um z.B. eine Oxidbarriere zwischen zwei Teilen der Halbleiterschicht zu bilden, so daß in jedes der beiden Teile der Halbleiterschicht andere Verunreinigungen diffundiert werden können.

6. Verfahren nach einem der vorhergehenden Ansprüche, bei welchem nach Bestrahlen der Halbleiterschicht mit einem Hochenergiestrahl die Halbleiterschicht selektiv geätzt wird, um eine Kontaktelektrode für einen Abschnitt des Substrats zu bilden, in den die Verunreinigung von der Halbleiterschicht diffundiert worden ist.

7. Verfahren nach einem der vorhergehenden Ansprüche, bei welchem die Halbleiterschicht entweder eine polykristalline Schicht oder eine amorphe Schicht ist.

8. Verfahren nach einem der vorhergehenden Ansprüche, dadurch gekennzeichnet, daß der Strahl hoher Energie ein Laserstrahl ist.

9. Verfahren nach einem der vorhergehenden Ansprüche, bei welchem zur Vorbereitung der Bestrahlung der Halbleiterschicht mit einem Strahl hoher Energie das Substrat erwärmt wird.

10. Verfahren nach einem der vorhergehenden Ansprüche, dadurch gekennzeichnet, daß die Halbleiterschicht und das Halbleitersubstrat aus Silizium bestehen.

Fig 1 A    Prior   art

2

P    1

Fig 1 B    Prior   art

3

2

2

P    1

Fig 1 C    Prior   art

3

2

n    5    1

P

Fig 1D    Prior art

6

3

2

n

5

1

P

Fig. 1E    Prior art

7

4

3

2

n

5

1

P

Fig 2A    Prior art

Fig 2B    prior art

Fig 2C    Prior art

Fig 3A

22 / 22

P - sub

21

Fig 3B

n

31

$n^+$

30

P - Sub

21

Fig 3C

32

n

31

$n^+$

30

P - sub

21

Fig 3D

Fig 3E

Fig 3F

**Fig 3G**

**Fig 3H**

**Fig 3I**

Fig 4A

Fig 4B

Fig 4C

Fig 4D

Fig 4E

Fig 4F

Fig 4G